# EUROPEAN PATENT APPLICATION

(11) **EP 4 746 108 A1**
(43) Date of publication of application: **20.05.2026**
(21) Application number: 25213875.5
(22) Date of filing: 06.11.2025
(51) Int. Cl.: H01M 10/42, H01M 10/44

(54) **METHOD OF MEASURING EXPANSION AMOUNT OF ELECTRICITY STORAGE DEVICE, AND APPARATUS OF MEASURING EXPANSION AMOUNT OF ELECTRICITY STORAGE DEVICE**

(30) Priority: 19.11.2024 JP 2024201726
(71) Applicant: Prime Planet Energy & Solutions, Inc., Tokyo 103-0022 (JP)
(72) Inventor: SHIBANO, Takuya, Tokyo,, 103-0022 (JP); ITO, Yuto, Tokyo,, 103-0022 (JP); SOEJIMA, Takanori, Tokyo,, 103-0022 (JP)
(74) Representative: Kuhnen & Wacker Patent- und Rechtsanwaltsbüro PartG mbB

(57) **Abstract**

A method of measuring an expansion amount of an electricity storage device includes a first imaging step, a charging and discharging step, a second imaging step, and a calculating step. In the first imaging step, an image of a right side surface of an outer container is taken in a front-rear direction while an electricity storage amount of the electricity storage device is at a first electricity storage amount. In the charging and discharging step, the electricity storage device is charged or discharged so that the electricity storage amount of the electricity storage device changes from the first electricity storage amount to a second electricity storage amount. In the second imaging step, an image of the right side surface of the outer container is taken in the front-rear direction while the electricity storage amount of the electricity storage device is at a second electricity storage amount. In the calculating step, the expansion amount of the outer container is calculated from the image obtained in the first imaging step and the image obtained in the second imaging step.

## Description

### BACKGROUND

The present invention relates to a method of measuring the expansion amount of an electricity storage device, and an apparatus of measuring the expansion amount of an electricity storage device.

JP 2023-113249 A discloses a technique related to a method of evaluating an inter-foil distance in a flat laminated part of an electrode body of an electricity storage device, in which electrode plates are laminated flatly. This method includes an inter-foil distance acquisition step, an average deviation calculation step, a reference distance acquisition step, and an evaluation step. The inter-foil distance acquisition step performs an X-ray CT analysis for the flat laminated part of the electrode body of the electricity storage device, in which electrode plates are laminated flatly. The inter-foil distance acquisition step acquires 10 or more inter-foil distances between the electrode foils contained in adjacent electrode plates of different polarities or in adjacent electrode plates of the same polarity that are separated by one with a different polarity, for the evaluation locations of the flat laminated part that contain a plurality of electrode plates. The average deviation calculation step calculates an average value and a standard deviation of the acquired inter-foil distances. The reference distance acquisition step acquires an evaluation reference distance obtained by adding three times the standard deviation to the average value. The evaluation step determines whether or not an over-reference inter-foil distance that is greater than the evaluation reference distance exists among the acquired inter-foil distances.

### SUMMARY

Electricity storage devices may undergo expansion in association with charging and discharging. The present inventor wishes to measure the expansion amount of an electricity storage device resulting from charging and discharging.

The present disclosure discloses a method of measuring an expansion amount of an electricity storage device including an outer container and an electrode body housed in the outer container by measuring the expansion amount of the outer container resulting from charging and discharging. The method of measuring an expansion amount of an electricity storage device includes: a first imaging step of capturing an image of one side surface of the outer container in a direction along an extending direction of the one side surface while an electricity storage amount of the electricity storage device is at a first electricity storage amount; a charging and discharging step of charging or discharging the electricity storage device so that the electricity storage amount of the electricity storage device changes from the first electricity storage amount to a second electricity storage amount; a second imaging step of capturing an image of the one side surface of the outer container in the direction along the extending direction of the one side surface while the electricity storage amount of the electricity storage device is at the second electricity storage amount; and a calculating step of calculating the expansion amount of the outer container from an image obtained in the first imaging step and an image obtained in the second imaging step.

With this expansion amount measuring method, it is possible to measure the expansion amount of an electricity storage device resulting from charging and discharging.

### BRIEF DESCRIPTION OF THE DRAWINGS

Fig. 1 is a perspective view schematically illustrating an electricity storage device.
Fig. 2 is a cross-sectional view taken along line A-A in Fig. 1.
Fig. 3 is a schematic view of an electrode body.
Fig. 4 is a flowchart illustrating one example of a method of measuring an expansion amount of an electricity storage device.
Fig. 5 is a schematic view illustrating an expansion amount measuring apparatus.
Fig. 6 is a plan view schematically illustrating the expansion amount measuring apparatus.
Fig. 7 is a graph illustrating one example of the intensity distribution of the X-ray transmitted light obtained in a first imaging step.
Fig. 8 is a graph obtained by differentiating the graph of Fig. 7 with respect to the position along the lateral direction.

### DETAILED DESCRIPTION

Hereinbelow, embodiments of the technology according to the present disclosure will be described with reference to the drawings. It should be noted, however, that the embodiments disclosed herein are, of course, not intended to limit the invention. The features and components that exhibit the same effects are designated by the same reference symbols as appropriate, and the description thereof will not be repeated as appropriate. In the drawings, reference characters X, Y, and Z represent the front-rear direction, the lateral direction, and the vertical direction, respectively. The lateral direction is orthogonal to the front-rear direction. The vertical direction is orthogonal to the front-rear direction and the lateral direction. Reference characters F, Rr, L, R, U, and D in the drawings represent front, rear, left, right, up, and down, respectively. Unless specifically stated otherwise, the recitation of numerical ranges herein, such as "A to B", is meant to include any values between the upper limits and the lower limits, inclusive, that is, "greater than or equal to A to less than or equal to B".

In the present description, the term "electricity storage device" refers to a device that is capable of charging and discharging. The electricity storage device may include a variety of batteries generally referred to as lithium-ion batteries and lithium secondary batteries, as well as batteries such as lithium polymer batteries and nickel-metal hydride batteries. The secondary battery refers to a battery that is capable of charging and discharging repeatedly in association with transfer of charge carriers between positive and negative electrodes. The electricity storage device may use either an electrolyte solution or a solid electrolyte. For example, the secondary battery may be a secondary battery that uses what is called a liquid-type electrolyte solution, or may be what is called an all-solid-state battery. The electricity storage device may also include capacitors, such as electric double layer capacitors and lithium-ion capacitors.

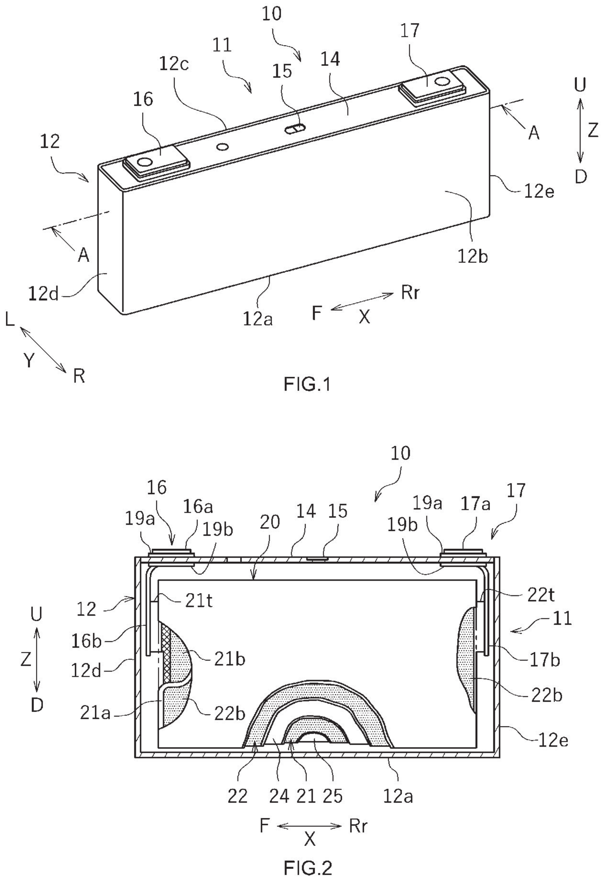

Fig. 1 is a perspective view schematically illustrating an electricity storage device 10. Fig. 2 is a cross-sectional view taken along line A-A in Fig. 1. Fig. 2 illustrates an electrode body 20 in a partial cross-sectional view in which it is partially cut out. The electricity storage device 10 includes a case 11 and an electrode body 20.

The case 11 includes an outer container 12 and a sealing plate 14. The outer container 12 is formed in a substantially rectangular parallelepiped shape. The outer container 12 includes a bottom surface 12a, a right side surface 12b, a left side surface 12c, a front side surface 12d, and a rear side surface 12e. The bottom surface 12a extends in a front-rear direction and a lateral direction. The right side surface 12b extends upward from a right end portion of the bottom surface 12a. The left side surface 12c extends upward from a left end portion of the bottom surface 12a. The right side surface 12b and the left side surface 12c are opposed to each other in a lateral direction. The right side surface 12b is one example of one side surface of the outer container 12. The left side surface 12c is one example of an opposing surface of the outer container 12. The front side surface 12d extends upward from a front end portion of the bottom surface 12a. The front side surface 12d connects the front end of the right side surface 12b and the front end of the left side surface 12c. The rear side surface 12e extends upward from a rear end portion of the bottom surface 12a. The rear side surface 12e connects the rear end of the right side surface 12b and the rear end of the left side surface 12c. The front side surface 12d and the rear side surface 12e are opposed to each other in a front-rear direction. An upper portion of the outer container 12 is open. From the viewpoints of reducing weight and providing sufficient rigidity, the outer container 12 is formed of, for example, aluminum, an aluminum alloy, or the like.

The sealing plate 14 is fitted to the open end of the outer container 12. The sealing plate 14 closes the open end of the outer container 12. The sealing plate 14 is joined to the outer container 12 by using, for example, welding. By joining the sealing plate 14 to the outer container 12, the inside of the case 11 is hermetically sealed. The sealing plate 14 constitutes the upper surface of the case 11. The sealing plate 14 may be formed of the same material as the outer container 12. From the viewpoints of reducing weight and providing sufficient rigidity, the sealing plate 14 may be formed of, for example, aluminum, an aluminum alloy, or the like. The sealing plate 14 is provided with a gas vent valve 15, a positive electrode terminal 16, and a negative electrode terminal 17.

The gas vent valve 15 is provided at a middle portion along the front-rear direction of the sealing plate 14. The gas vent valve 15 ruptures when the pressure inside the case 11 rises higher than or equal to a predetermined value. This allows the gas inside the case 11 to be expelled outside the case 11 when the pressure inside the case 11 reaches higher than or equal to the predetermined pressure.

The positive electrode terminal 16 and the negative electrode terminal 17 are provided on the opposite ends of the front-rear direction of the sealing plate 14 to form a pair. In the embodiment shown in Fig. 1, the positive electrode terminal 16 is disposed forward relative to the negative electrode terminal 17. The positive electrode terminal 16 includes an external terminal 16a and an internal terminal 16b. The external terminal 16a is attached to the upper side of the sealing plate 14 with a gasket 19a interposed. The internal terminal 16b is attached to the lower side of the sealing plate 14 with an insulator 19b interposed. The internal terminal 16b extends in a vertical direction. The internal terminal 16b is electrically connected to the electrode body 20 within the case 11.

The negative electrode terminal 17 includes an external terminal 17a and an internal terminal 17b. The external terminal 17a is attached to the upper side of the sealing plate 14 with a gasket 19a interposed. The internal terminal 17b is attached to the lower side of the sealing plate 14 with an insulator 19b interposed. The internal terminal 17b extends in a vertical direction. The internal terminal 17b is electrically connected to the electrode body 20 within the case 11.

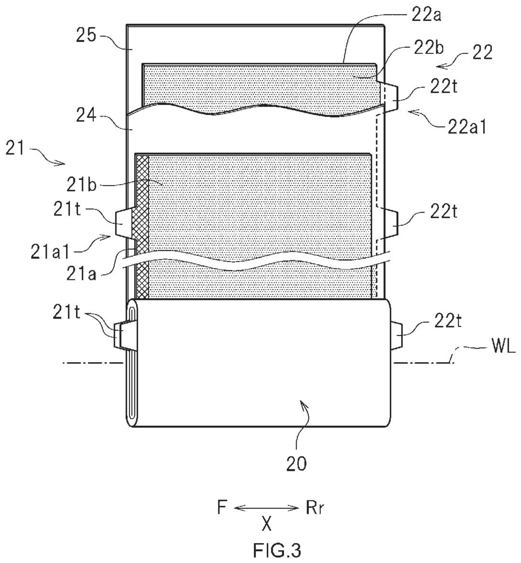

Fig. 3 is a schematic view of the electrode body 20. The electrode body 20 in the present embodiment is what is called a wound electrode body. The electrode body 20 includes a long-size positive electrode sheet 21, a long-size negative electrode sheet 22, and sheet-shaped separators 24 and 25. The electrode body 20 is constructed by winding the positive electrode sheet 21, the separators 24 and 25, and the negative electrode sheet 22 around the winding axis WL in a longitudinal direction with them being stacked on each other and forming them in a flat shape. As illustrated in Fig. 2, the electrode body 20 is housed inside the case 11. As illustrated in Fig. 2, the electrode body 20 is disposed inside the case 11 so that the winding axis WL is substantially parallel to the front-rear direction. Accordingly, in the embodiment shown in Fig. 2, the positive electrode sheet 21 and the negative electrode sheet 22 are stacked in a lateral direction. In other words, in the embodiment shown in Fig. 2, the stacking direction of the positive electrode sheet 21 and the negative electrode sheet 22 extends in a lateral direction. A pair of right side surface 12b and left side surface 12c are disposed on opposing sides of the stacking direction of the positive electrode sheet 21 and the negative electrode sheet 22. However, the configuration of the electrode body 20 is not limited thereto. The electrode body 20 may also be, for example, what is called a laminated electrode body, in which a plurality of rectangular-shaped positive electrode sheets 21 and a plurality of rectangular-shaped negative electrode sheets 22 are laminated with them being insulated from each other.

As illustrated in Fig. 3, the positive electrode sheet 21 includes a foil-shaped positive electrode current collector 21a and a positive electrode active material layer 21b formed on both faces of the positive electrode current collector 21a along the longitudinal axis. The positive electrode active material layer 21b contains various types of materials, such as a positive electrode active material, a binder, a conductive agent, and so forth. On one side edge portion of the electrode body 20 with respect to the front-rear direction of the electricity storage device 10, the positive electrode active material layer 21b is not formed but is provided with an uncoated portion 21a1 from which the positive electrode current collector 21a is exposed. The uncoated portion 21a1 is provided with a plurality of positive electrode tabs 21t disposed intermittently at predetermined positions along the longitudinal axis of the positive electrode sheet 21. Each of the plurality of positive electrode tabs 21t protrudes in a front-rear direction of the positive electrode sheet 21. In the embodiment shown in Fig. 2, the plurality of positive electrode tabs 21t are disposed so that the positions of the plurality of positive electrode tabs 21t are aligned when the positive electrode sheet 21 is in a wound state. The positive electrode tabs 21t are electrically connected to the internal terminal 16b of the positive electrode terminal 16.

The negative electrode sheet 22 includes a foil-shaped negative electrode current collector 22a and a negative electrode active material layer 22b formed on one or both faces of the negative electrode current collector 22a along the longitudinal axis. The negative electrode active material layer 22b contains various types of materials, such as a negative electrode active material, a binder, and so forth. On the other side edge portion of the electrode body 20 with respect to the front-rear direction of the electricity storage device 10, the negative electrode active material layer 22b is not formed but is provided with an uncoated portion 22a1 from which the negative electrode current collector 22a is exposed. The uncoated portion 22a1 is provided with a plurality of negative electrode tabs 22t disposed intermittently at predetermined positions along the longitudinal axis of the negative electrode sheet 22. Each of the plurality of negative electrode tabs 22t protrudes in a front-rear direction of the negative electrode sheet 22. In the embodiment shown in Fig. 2, the plurality of negative electrode tabs 22t are disposed so that the positions of the plurality of negative electrode tabs 22t are aligned when the negative electrode sheet 22 is in a wound state. The negative electrode tabs 22t are electrically connected to the internal terminal 17b of the negative electrode terminal 17.

The separators 24 and 25 are interposed between the positive electrode sheet 21 and the negative electrode sheet 22 to prevent the positive electrode sheet 21 and the negative electrode sheet 22 from being directly in contact with each other. Although not shown in the drawings, the separators 24 and 25 are provided with a plurality of very small holes formed therein. These very small holes are configured to cause the charge carriers to be transferred between the positive electrode sheet 21 and the negative electrode sheet 22. Note that the term "charge carrier" refers to a particle that carries an electric charge. For example, in the case of lithium-ion secondary batteries, the charge carrier is a lithium ion. For the separators 24 and 25, it is possible to use a resin sheet or the like that has required heat resistance.

The electricity storage device 10 such as described above may undergo expansion in association with charging and discharging. The present inventor wishes to measure the expansion amount of the electricity storage device 10 due to charging and discharging.

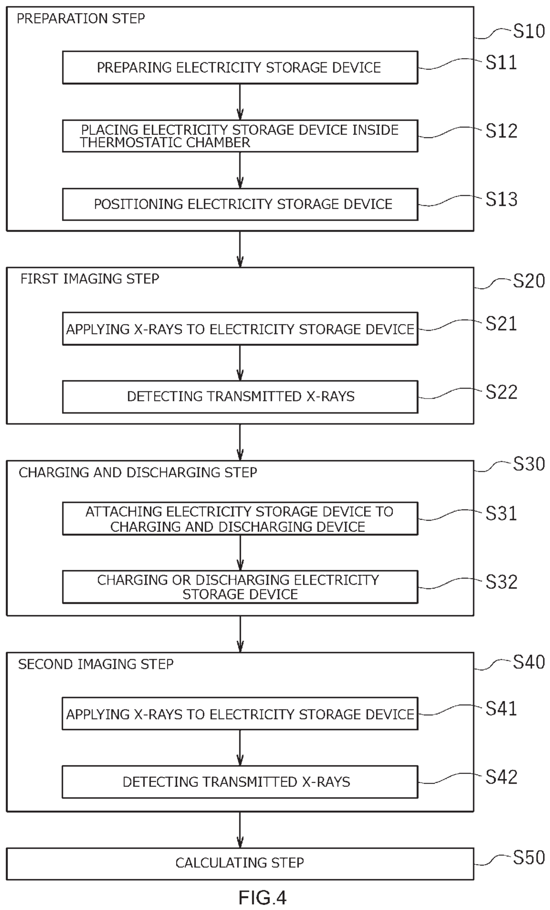

Fig. 4 is a flowchart illustrating one example of a method of measuring the expansion amount of the electricity storage device 10. As illustrated in Fig. 4, the method of measuring the expansion amount of the electricity storage device 10 includes a preparation step S10, a first imaging step S20, a charging and discharging step S30, a second imaging step S40, and a calculating step S50. Measurement of the expansion amount of the electricity storage device 10 is implemented using an expansion amount measuring apparatus 50. Measurement of the expansion amount of the electricity storage device 10 may be performed for the purpose of checking the status of a used electricity storage device 10 or may be performed as part of the testing during the manufacturing process of the electricity storage device 10.

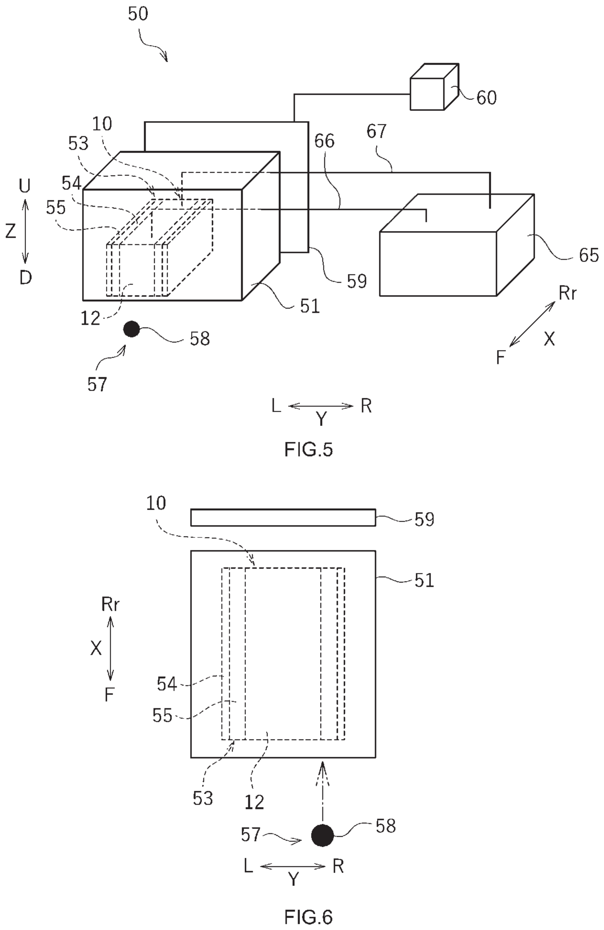

Fig. 5 is a schematic view of the expansion amount measuring apparatus 50. The expansion amount measuring apparatus 50 includes a thermostatic chamber 51, a restraining member 53, an imaging device 57, and a calculation device 60. The thermostatic chamber 51 is formed into a box shape. The electricity storage device 10 is placed inside the thermostatic chamber 51. The thermostatic chamber 51 is configured to be capable of controlling the temperature inside the thermostatic chamber 51. Although not shown in the drawings, the thermostatic chamber 51 may also be provided with, for example, a heater for heating the interior of the thermostatic chamber 51, a temperature sensor for measuring the temperature inside the thermostatic chamber 51, a controller controlling the heater based on the measurement results of the temperature sensor, and so forth. It is preferable that the thermostatic chamber 51 be composed of a material having an X-ray transmission rate higher than a predetermined value. The thermostatic chamber 51 may be made of, for example, a plastic material or may also be made of aluminum or the like. When the expansion amount is measured with the electricity storage device 10 being placed inside the thermostatic chamber 51 in such a way, variations in the expansion amount due to temperature variation can be reduced, and therefore, measurement of the expansion amount due to charging and discharging can be carried out with high accuracy.

The restraining member 53 is provided inside the thermostatic chamber 51. The restraining member 53 restrains the electricity storage device 10 so as to press the right side surface 12b and the left side surface 12c of the outer container 12 from outside. The configuration of the restraining member 53 is not particularly limited to any configuration. In the embodiment shown in Fig. 5, the restraining member 53 includes a cushioning member 54 and a metal plate 55. The cushioning member 54 is a member that is pressed against the electricity storage device 10. The cushioning member 54 is made of a material that is different from the material that makes up the outer container 12. The cushioning member 54 may be made of, for example, various types of rubber materials, resin materials with flexibility, or the like. The metal plate 55 is disposed on the left and right outer sides of the cushioning member 54. The metal plate 55 is made of a material that is different from the material that makes up the cushioning member 54. The metal plate 55 may be made of, for example, aluminum.

The imaging device 57 takes an image of one side surface of the outer container 12 in a direction along the extending direction of the one side surface, with the electricity storage device 10 being restrained by the restraining member 53. In the embodiment shown in Fig. 5, the imaging device 57 takes an image of the right side surface 12b of the outer container 12 in a front-rear direction. In the embodiment shown in Fig. 5, the imaging device 57 is disposed outside the thermostatic chamber 51. In the embodiment shown in Fig. 5, the imaging device 57 includes a light source 58 that applies X-rays in a front-rear direction and an X-ray detector 59 that detects the transmitted light of the X-rays applied from the light source 58. The light source 58 is disposed in front of the thermostatic chamber 51. The light source 58 generates X-rays and applies the X-rays toward the thermostatic chamber 51. The method in which the light source 58 generates X-rays is not limited to any particular method, and various types of conventionally known methods may be used. The X-ray detector 59 is disposed rearward of the thermostatic chamber 51. This means that the thermostatic chamber 51 is disposed between the light source 58 and the X-ray detector 59 with respect to the front-rear direction. The X-ray detector 59 is a device that detects the intensity of the X-rays applied from the light source 58 and transmitted through the thermostatic chamber 51. The method in which the X-ray detector 59 detects the intensity of X-rays is not limited to any particular method, and various types of conventionally known methods may be used.

The calculation device 60 calculates the expansion amount of the outer container 12 caused by charging to and discharging from the electricity storage device 10. The calculation device 60 calculates the expansion amount of the outer container 12 from the X-ray intensity distribution detected by the X-ray detector 59. The calculation device 60 may also be configured by, for example, a computer including a storage, a memory, and a processor. The storage stores programs and data that are required when the processor executes various types of processes. The memory works as a work area for the processor.

As illustrated in Fig. 4, the preparation step S10 includes step S11 of preparing the electricity storage device 10, step S12 of placing the electricity storage device 10 in the expansion amount measuring apparatus 50, and step S13 of positioning the electricity storage device 10.

In step S11, the electricity storage device 10 that is to be measured in the expansion amount measurement is prepared. The electricity storage device 10 to be prepared in step S11 may be a new one or a used one. In step S12, the electricity storage device 10 prepared in step S11 is placed in the thermostatic chamber 51. In step S12, the restraining member 53 is fitted to the right side surface 12b and the left side surface 12c of the outer container 12. In the embodiment shown in Fig. 5, the electricity storage device 10 is placed so that the front side surface 12d of the outer container 12 faces toward the light source 58.

Fig. 6 is a plan view schematically illustrating the expansion amount measuring apparatus 50. In step S13, positioning is performed between the light source 58 and the electricity storage device 10. In step S13, positioning is performed so that the X-ray light source 58 is disposed forward relative to the front side surface 12d of the outer container 12 and at the same position as the corner of the outer container 12 that is formed by the front side surface 12d and the right side surface 12b with respect to the lateral direction. Specifically, in step S13, positioning is performed so that the X-ray light source 58 and the right end of the front side surface 12d of the outer container 12 are disposed at the same position with respect to the lateral direction. Herein, the phrase "same position" means to include both cases when they are exactly at the same position and when they are approximately at the same position. The positioning may be performed by, for example, applying X-rays from the light source 58 to the electricity storage device 10 placed in the thermostatic chamber 51 and checking whether or not an appropriate intensity distribution of X-ray transmitted light is obtained.

In the first imaging step S20, an image of one side surface of the outer container 12 is taken in a direction along the extending direction of the one side surface, with the electricity storage amount of the electricity storage device 10 being at a first electricity storage amount. The first imaging step S20 is performed with the restraining member 53 fitted to the outer container 12. In the embodiment shown in Fig. 5, an image of the right side surface 12b of the outer container 12 is taken in a front-rear direction, with the restraining member 53 fitted to the outer container 12. The first imaging step S20 includes step S21 of applying X-rays in a direction along one side surface of the outer container 12 and step S22 of imaging transmitted light of the applied X-rays. In the embodiment shown in Fig. 5, in step S21, X-rays are applied from the front toward the rear along the right side surface 12b of the outer container 12. In the embodiment shown in Fig. 5, in step S22, the intensity of the X-rays transmitted through the thermostatic chamber 51 is detected by the X-ray detector 59. This allows step S22 to obtain the intensity distribution of the X-ray transmitted light in lateral directions and vertical directions.

In the charging and discharging step S30, the electricity storage device 10 is charged or discharged so that the electricity storage amount of the electricity storage device 10 changes from the first electricity storage amount to a second electricity storage amount. The charging and discharging step S30 includes step S31 of attaching the electricity storage device 10 to a charging and discharging device 65 and step S32 of charging or discharging the electricity storage device 10.

In step S31, the electricity storage device 10 is attached to the charging and discharging device 65. In the embodiment shown in Fig. 5, the electricity storage device 10 is attached to the charging and discharging device 65 by connecting the positive electrode terminal 16 and the charging and discharging device 65 by an electric cable 66 and connecting the negative electrode terminal 17 and the charging and discharging device 65 by an electric cable 67. The charging and discharging device 65 is a device that charges or discharges the electricity storage device 10. The configuration of the charging and discharging device 65 is not limited to any particular configuration. For the charging and discharging device 65, it is possible to use any conventionally known charging and discharging device without any particular limitation.

In step S32, the electricity storage device 10 is charged or discharged so that the electricity storage amount of the electricity storage device 10 changes from the first electricity storage amount to the second electricity storage amount. It should be noted that the second electricity storage amount may be greater than the first electricity storage amount or less than the first electricity storage amount. When the second electricity storage amount is greater than the first electricity storage amount, the electricity storage device 10 is charged in step S32. When the second electricity storage amount is less than the first electricity storage amount, the electricity storage device 10 is discharged in step S32. For example, the first electricity storage amount and the second electricity storage amount may be set to a predetermined value within the range of 0% to 100% of SOC (state of charge). The charging and discharging C-rate in step S32 is not limited to any particular C-rate.

In the second imaging step S40, an image of one side surface of the outer container 12 is taken in a direction along the extending direction of the one side surface, with the electricity storage amount of the electricity storage device 10 being at the second electricity storage amount. The second imaging step S40 is performed with the restraining member 53 fitted to the outer container 12. In the embodiment shown in Fig. 5, an image of the right side surface 12b of the outer container 12 is taken in a front-rear direction, with the restraining member 53 fitted to the outer container 12. In the present embodiment, the second imaging step S40 is performed with the same positional relationship between the electricity storage device 10 and the X-ray light source 58 as that when the first imaging step S20 was performed. The second imaging step S40 includes step S41 of applying X-rays in a direction along one side surface of the outer container 12 and step S42 of detecting transmitted light of the applied X-rays. In the embodiment shown in Fig. 5, in step S41, X-rays are applied from the front toward the rear along the right side surface 12b of the outer container 12. In the embodiment shown in Fig. 5, in step S42, the intensity of the transmitted light of the X-rays transmitted through the thermostatic chamber 51 is detected by the X-ray detector 59. This allows step S42 to obtain the intensity distribution of the X-ray transmitted light in lateral directions and vertical directions.

The calculating step S50 is executed by the calculation device 60. In the calculating step S50, the expansion amount of the outer container 12 is calculated from the image obtained in the first imaging step S20 and the image obtained in the second imaging step S40. In the present embodiment, in the calculating step S50, the expansion amount of the outer container 12 is calculated from the intensity distribution of the X-ray transmitted light obtained in the first imaging step S20 and the intensity distribution of the X-ray transmitted light obtained in the second imaging step S40.

The following describes one example of the method of calculating the expansion amount of the outer container 12 that is executed in the calculating step S50.

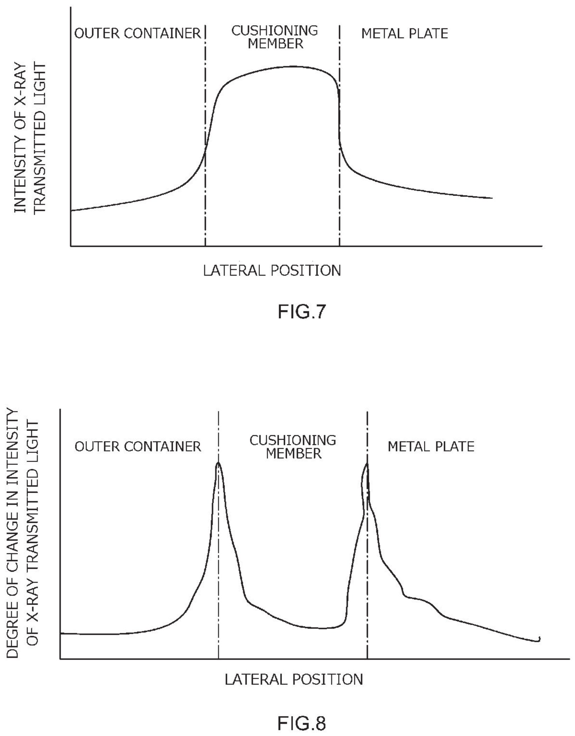

Fig. 7 is a graph illustrating one example of the intensity distribution of the X-ray transmitted light obtained in the first imaging step S20. Fig. 7 shows the intensity distribution of the X-ray transmitted light at a position equivalent to the middle portion along the vertical direction of the electricity storage device 10. The horizontal axis in Fig. 7 represents positions along the lateral direction. The vertical axis in Fig. 7 represents the intensity of X-ray transmitted light at each respective position along the lateral direction. The outer container 12 and the cushioning member 54 have different X-ray transmission rates because they are made of different materials from each other. Likewise, the cushioning member 54 and the metal plate 55 have different X-ray transmission rates because they are made of different materials from each other. Therefore, as illustrated in Fig. 7, the intensity of X-ray transmitted light changes significantly at respective boundary portions between the outer container 12, the cushioning member 54, and the metal plate 55.

Fig. 8 is a graph obtained by differentiating the graph of Fig. 7 with respect to the position along the lateral direction. Accordingly, the vertical axis in Fig. 8 represents the degree of change in the intensity of X-ray transmitted light at each respective position along the lateral direction. As mentioned earlier, the intensity of X-ray transmitted light changes significantly at respective boundary portions between the outer container 12, the cushioning member 54, and the metal plate 55. Thus, the degree of change in the intensity of X-ray transmitted light increases at respective boundary portions between the outer container 12, the cushioning member 54, and the metal plate 55. Therefore, differentiating the graph of Fig. 7 with respect to the positions along the lateral direction yields a graph with two local maximum values, as illustrated in Fig. 8. The positions with respect to the lateral direction corresponding to these two local maximum values are the positions of the respective boundary portions between the outer container 12, the cushioning member 54, and the metal plate 55. Thus, by calculating the positions of the respective boundary portions between the outer container 12, the cushioning member 54, and the metal plate 55 in this manner, it is possible to identify the positions of the respective boundary portions between the outer container 12, the cushioning member 54, and the metal plate 55 with respect to the lateral direction.

In the above-described manner, the positions of the respective boundary portions between the outer container 12, the cushioning member 54, and the metal plate 55 at the time of executing the first imaging step S20 can be identified from the intensity distribution of the X-ray transmitted light obtained in the first imaging step S20. Also, by performing the same process for the intensity distribution graph of the X-ray transmitted light obtained in the second imaging step S40, the positions of the respective boundary portions between the outer container 12, the cushioning member 54, and the metal plate 55 at the time of executing the second imaging step S40 can be identified.

When the electricity storage device 10 expands in association with charging and discharging, the position of the boundary portion between the outer container 12 and the cushioning member 54 changes. Accordingly, by comparing the position of the boundary portion between the outer container 12 and the cushioning member 54 at the time of executing the first imaging step S20 and the position of the boundary portion between the outer container 12 and the cushioning member 54 at the time of executing the second imaging step S40, it is possible to identify the amount of displacement of the position of the boundary portion between the outer container 12 and the cushioning member 54. Thus, from this amount of displacement, the expansion amount of the electricity storage device 10 can be calculated.

According to the present embodiment, the method of measuring the expansion amount of the electricity storage device 10 includes the first imaging step S20, the charging and discharging step S30, the second imaging step S40, and the calculating step S50. In the first imaging step S20, an image of the right side surface 12b of the outer container 12 is taken in a front-rear direction while the electricity storage amount of the electricity storage device 10 is at a first electricity storage amount. In the charging and discharging step S30, the electricity storage device 10 is charged or discharged so that the electricity storage amount of the electricity storage device 10 changes from the first electricity storage amount to a second electricity storage amount. In the second imaging step S40, an image of the right side surface 12b of the outer container 12 is taken in a front-rear direction while the electricity storage amount of the electricity storage device 10 is at the second electricity storage amount. In the calculating step S50, the expansion amount of the outer container 12 is calculated from the image obtained in the first imaging step S20 and the image obtained in the second imaging step S40. With this expansion amount measuring method, it is possible to measure the expansion amount of the electricity storage device 10 resulting from charging and discharging in a non-contact manner and on site.

In the present embodiment, an image of the right side surface 12b of the outer container 12 is taken in a front-rear direction in the first imaging step S20 and the second imaging step S40. The right side surface 12b of the outer container 12 is one of the side surfaces that are disposed on opposing sides of the stacking direction of the positive electrode sheet 21 and the negative electrode sheet 22 of the electrode body 20. The pair of side surfaces of the outer container 12 that are disposed on opposing sides of the stacking direction of the positive electrode sheet 21 and the negative electrode sheet 22 in this way are the side surfaces that expand most significantly among the side surfaces of the outer container 12. Thus, because the right side surface 12b of the outer container 12 is a side surface that is likely to expand, measuring the expansion amount of the right side surface 12b of the outer container 12 makes it easy to determine whether the expansion amount of the electricity storage device 10 is normal or abnormal.

According to the present embodiment, the first imaging step S20 includes step S21 of applying X-rays in a front-rear direction to the right side surface 12b of the outer container 12 and step S22 of detecting transmitted light of the X-rays that have been applied in step S21 of applying X-rays. The second imaging step S40 includes step S41 of applying X-rays in a front-rear direction to the right side surface 12b of the outer container 12 and step S42 of detecting transmitted light of the X-rays that have been applied in step S41 of applying X-rays. In the calculating step S50, the expansion amount of the outer container 12 is calculated from the intensity distribution of the transmitted light obtained in the first imaging step S20 and the intensity distribution of the transmitted light obtained in the second imaging step S40. With this measuring method, the expansion amount of the outer container 12 is calculated by detecting X-ray transmitted light and comparing the intensity distribution. This enables the expansion amount of the outer container 12 to be measured with higher accuracy than measuring the expansion amount from the images that are taken with visible light. It is also possible to measure the expansion amount even when the outer container 12 is restrained by the restraining member 53 because X-rays can transmit through the restraining member 53.

In the present embodiment, the first imaging step S20 and the second imaging step S40 are performed while the restraining member 53 that restrains the right side surface 12b and the left side surface 12c of the outer container 12 so as to press them from outside is fitted to the outer container 12. This makes it possible to measure the expansion amount of the outer container 12 under a condition similar to the actual use condition in which the electricity storage device 10 is restrained as a stack.

According to the present embodiment, the X-ray light source 58 is disposed forward relative to the front side surface 12d and at substantially the same position as the corner of the outer container 12 that is formed by the front side surface 12d and the right side surface 12b with respect to the lateral direction. When the light source 58 is disposed in this manner, X-rays reach the right side surface 12b almost without transmitting through the front side surface 12d. As a result, measurement of the expansion amount can be performed with high accuracy.

Hereinabove, an embodiment of the technology proposed herein has been described. It should be noted, however, that the foregoing embodiment is merely exemplary and the invention may be embodied in various other forms.

In the foregoing embodiment, the imaging step of capturing an image of one side surface of the outer container 12 is performed two times, the first imaging step S20 and the second imaging step S40. However, it is also possible that the step of capturing an image of one side surface of the outer container 12 may be performed three or more times. When this is the case, the electricity storage amounts in the respective imaging steps may be different from each other.

In the foregoing embodiment, measurement of the expansion amount is carried out with the electricity storage device 10 being placed in the thermostatic chamber 51. However, when measuring the expansion amount of the electricity storage device 10, it is not always necessary to place the electricity storage device 10 to be measured inside the thermostatic chamber 51. In the foregoing embodiment, measurement of the expansion amount is carried out with the restraining member 53 fitted to the electricity storage device 10. However, measurement of the expansion amount of the electricity storage device 10 may be performed while the electricity storage device 10 to be measured is not fitted to the restraining member 53. When measurement of the expansion amount is performed while the electricity storage device 10 is not placed inside the thermostatic chamber 51 and the restraining member 53 is not fitted to the electricity storage device 10, it is possible to perform the measurement, for example, using a camera. When this is the case, for example, the calculation device 60 may perform image processing for the images taken by the camera, and thereby the calculation device 60 may calculate the amount of displacement of the position of the boundary portion between the outer container 12 and the cushioning member 54, to calculate the expansion amount.

The foregoing embodiment measures the expansion amount of the electricity storage device 10 by measuring the expansion amount of the right side surface 12b of the outer container 12. However, it is also possible to measure the expansion amount of the electricity storage device 10 by measuring the expansion amount of the left side surface 12c of the outer container 12. When measurement is performed in this way, it is preferable that the X-ray light source 58 be at the same position as the left corner of the outer container 12 that is formed by the front side surface 12d and the left side surface 12c with respect to the lateral direction.

Various embodiments of the technology according to the present disclosure have been described hereinabove. Unless specifically stated otherwise, the embodiments described herein do not limit the scope of the present invention. It should be noted that various other modifications and alterations may be possible in the embodiments of the technology disclosed herein. In addition, the features, structures, or steps described herein may be omitted as appropriate, or may be combined in any suitable combinations, unless specifically stated otherwise. In addition, the present description includes the disclosure as set forth in the following items.

### Item 1:

A method of measuring an expansion amount of an electricity storage device including an outer container and an electrode body housed in the outer container by measuring an expansion amount of the outer container resulting from charging and discharging, the method including:
a first imaging step of capturing an image of one side surface of the outer container in a direction along an extending direction of the one side surface while an electricity storage amount of the electricity storage device is at a first electricity storage amount;
a charging and discharging step of charging or discharging the electricity storage device so that the electricity storage amount of the electricity storage device changes from the first electricity storage amount to a second electricity storage amount;
a second imaging step of capturing an image of the one side surface of the outer container in the direction along the extending direction of the one side surface while the electricity storage amount of the electricity storage device is at the second electricity storage amount; and
a calculating step of calculating the expansion amount of the outer container from an image obtained in the first imaging step and an image obtained in the second imaging step.

### Item 2:

The method of measuring an expansion amount of an electricity storage device according to item 1, wherein:
the electrode body is a laminated electrode body in which a plurality of electrode sheets are laminated; and
the one side surface is one of a pair of side surfaces disposed on opposing ends of a stacking direction of the plurality of electrode sheets.

### Item 3:

The method of measuring an expansion amount of an electricity storage device according to item 1, wherein:
the electrode body is an electrode body formed in a flat shape by winding or folding a long-size electrode sheet so as to be stacked; and
the one side surface is one of a pair of side surfaces disposed on opposing ends of a stacking direction of the electrode sheet.

### Item 4:

The method of measuring an expansion amount of an electricity storage device according to any one of items 1 through 3, wherein:
each of the first imaging step and the second imaging step includes a step of applying X-rays in a direction along the one side surface of the outer container and a step of detecting transmitted light of the X-rays applied in the step of applying the X-rays; and
in the calculating step, the expansion amount of the outer container is calculated from an intensity distribution of the transmitted light obtained in the first imaging step and an intensity distribution of the transmitted light obtained in the second imaging step.

### Item 5:

The method of measuring an expansion amount of an electricity storage device according to item 4, wherein the first imaging step and the second imaging step are performed while a restraining member restraining the one side surface of the outer container so as to press the one side surface from outside is fitted to the outer container.

### Item 6:

The method of measuring an expansion amount of an electricity storage device according to item 4 or 5, wherein:
the outer container further includes an opposing surface opposing the one side surface, and a front side surface connecting a front end of the one side surface and a front end of the opposing surface; and
a light source of the X-rays is disposed forward relative to the front side surface and at substantially a same position, with respect to an alignment direction of the one side surface and the opposing surface, as a corner of the outer container that is formed by the front side surface and the one side surface.

### Item 7:

An apparatus of measuring an expansion amount of an electricity storage device including an outer container and an electrode body housed in the outer container, the apparatus including:
a restraining member restraining the electricity storage device;
an imaging device imaging one side surface of the outer container in a direction along an extending direction of the one side surface with the electricity storage device being restrained by the restraining member; and
a calculation device calculating an expansion amount of the outer container resulting from charging and discharging of the electricity storage device, wherein
the calculation device calculates the expansion amount of the outer container from a first image of the one side surface of the outer container obtained by the imaging device while an electricity storage amount of the electricity storage device is at a first electricity storage amount, and a second image of the one side surface of the outer container obtained by the imaging device while the electricity storage amount of the electricity storage device is at a second electricity storage amount.

### Item 8:

The apparatus of measuring an expansion amount of an electricity storage device according to item 7, wherein:
the imaging device includes a light source applying X-rays in a direction along the one side surface of the outer container, and an X-ray detector detecting transmitted light of the X-rays applied from the light source; and
the calculation device calculates the expansion amount of the outer container from an intensity distribution of the transmitted light in the first image and an intensity distribution of the transmitted light in the second image.

## Claims

1. A method of measuring an expansion amount of an electricity storage device (10) including an outer container (12) and an electrode body (20) housed in the outer container (12) by measuring an expansion amount of the outer container (12) resulting from charging and discharging, the method comprising:
a first imaging step (S20) of capturing an image of one side surface (12b) of the outer container (12) in a direction along an extending direction of the one side surface (12b) while an electricity storage amount of the electricity storage device (10) is at a first electricity storage amount;
a charging and discharging step (S30) of charging or discharging the electricity storage device (10) so that the electricity storage amount of the electricity storage device (10) changes from the first electricity storage amount to a second electricity storage amount;
a second imaging step (S40) of capturing an image of the one side surface (12b) of the outer container (12) in the direction along the extending direction of the one side surface (12b) while the electricity storage amount of the electricity storage device (10) is at the second electricity storage amount; and
a calculating step (S50) of calculating the expansion amount of the outer container (12) from an image obtained in the first imaging step (S20) and an image obtained in the second imaging step (S40).

2. The method of measuring an expansion amount of an electricity storage device (10) according to claim 1, wherein:
the electrode body (20) is a laminated electrode body in which a plurality of electrode sheets (21, 22) are laminated; and
the one side surface (12b) is one of a pair of side surfaces disposed on opposing ends of a stacking direction of the plurality of electrode sheets (21, 22).

3. The method of measuring an expansion amount of an electricity storage device (10) according to claim 1, wherein:
the electrode body (20) is an electrode body formed in a flat shape by winding or folding a long-size electrode sheet (21, 22) so as to be stacked; and
the one side surface (12b) is one of a pair of side surfaces disposed on opposing ends of a stacking direction of the electrode sheet (21, 22).

4. The method of measuring an expansion amount of an electricity storage device (10) according to claims 1 to 3, wherein:
each of the first imaging step (S20) and the second imaging step (S40) includes a step (S21, S41) of applying X-rays in a direction along the one side surface (12b) of the outer container (12) and a step (S22, S42) of detecting transmitted light of the X-rays applied in the step of applying the X-rays; and
in the calculating step (S50), the expansion amount of the outer container (12) is calculated from an intensity distribution of the transmitted light obtained in the first imaging step (S20) and an intensity distribution of the transmitted light obtained in the second imaging step (S40).

5. The method of measuring an expansion amount of an electricity storage device (10) according to claim 4, wherein the first imaging step (S20) and the second imaging step (S40) are performed while a restraining member (53) restraining the one side surface (12b) of the outer container (12) so as to press the one side surface (12b) from outside is fitted to the outer container (12).

6. The method of measuring an expansion amount of an electricity storage device (10) according to claim 4 or 5, wherein:
the outer container (12) further includes an opposing surface (12c) opposing the one side surface (12b), and a front side surface (12d) connecting a front end of the one side surface (12b) and a front end of the opposing surface (12c); and
a light source (58) of the X-rays is disposed forward relative to the front side surface (12d) and at substantially a same position, with respect to an alignment direction of the one side surface (12b) and the opposing surface (12c), as a corner of the outer container (12b) that is formed by the front side surface (12d) and the one side surface (12b).

7. An apparatus (50) of measuring an expansion amount of an electricity storage device (10) including an outer container (12) and an electrode body (20) housed in the outer container (12), the apparatus (50) comprising:
a restraining member (53) restraining the electricity storage device (10);
an imaging device (57) imaging one side surface (12b) of the outer container (12) in a direction along an extending direction of the one side surface (12b) with the electricity storage device (10) being restrained by the restraining member (53); and
a calculation device (60) calculating an expansion amount of the outer container (12) resulting from charging and discharging of the electricity storage device (10), wherein
the calculation device (60) calculates the expansion amount of the outer container (12) from a first image of the one side surface (12b) of the outer container (12) obtained by the imaging device (57) while an electricity storage amount of the electricity storage device (10) is at a first electricity storage amount, and a second image of the one side surface (12b) of the outer container (12) obtained by the imaging device (57) while the electricity storage amount of the electricity storage device (10) is at a second electricity storage amount.

8. The apparatus (50) of measuring an expansion amount of an electricity storage device (10) according to claim 7, wherein:
the imaging device (57) includes a light source (58) applying X-rays in a direction along the one side surface (12b) of the outer container (12), and an X-ray detector (59) detecting transmitted light of the X-rays applied from the light source (58); and
the calculation device (60) calculates the expansion amount of the outer container (12) from an intensity distribution of the transmitted light in the first image and an intensity distribution of the transmitted light in the second image.
